Europäisches Patentamt

European Patent Office

Office européen des brevets

(11) Veröffentlichungsnummer: **0 211 208**
**A1**

## EUROPÄISCHE PATENTANMELDUNG

(21) Anmeldenummer: 86108556.1

(22) Anmeldetag: 23.06.86

(51) Int. Cl.⁴: **G02B 6/44**

(30) Priorität: 30.07.85 DE 3527278

(43) Veröffentlichungstag der Anmeldung:
25.02.87 Patentblatt 87/09

(84) Benannte Vertragsstaaten:
**AT BE CH DE FR GB LI NL SE**

(71) Anmelder: **Siemens Aktiengesellschaft Berlin
und München
Wittelsbacherplatz 2
D-8000 München 2(DE)**

(72) Erfinder: **Burmeister, Klaus-Dieter, Dipl.-Ing.
(FH)
Kranzhornstrasse 10
D-8000 München 82(DE)**
Erfinder: **Holbe, Erhard, Dipl.-Ing. (FH)
Saarbrückerstrasse 14
D-8000 München 70(DE)**
Erfinder: **Schreiner, Werner, Dipl.-Ing.
Neuhäuslerstrasse 3
D-8011 Höhenkirchen(DE)**

(54) **Verteiler für Lichtwellenleiter.**

(57) Der Verteiler weist blockartig aufeinanderge-schichtete Aufnahmen (3) für Verbinderbauteile (4) auf, die am Gestell (1) des Verteilers in der Schichtebene bewegbar gelagert sind. Dadurch können die Aufnahmen (3) einzeln aus den blockartig zusammengefaßten übrigen Bauteilen herausbewegt werden, so daß die Verbinderbauteile (4) frei zugänglich sind.

FIG 1

## Verteiler für Lichtwellenleiter

Die Erfindung bezieht sich auf Verteiler für Lichtwellenleiter mit schichtartig aneinandergereihten flachen Aufnahmen für Verbinderbauteile, die an einem Gestell des Verteilers gelagert sind.

Bei elektrischen Verteilern in Fernsprechämtern ist ein derartiger schichtartiger Aufbau von Verteilerbausteinen allgemein üblich, wie dies z.B. den Unterlagen des DE-Gm 69 13 011 entnehmbar ist. Die elektrischen Leitungen sind dabei von der Rückseite her an Anschlußelemente der Verteilerfrontseite herangeführt. Das Herstellen und Ändern von elektrischen Verbindungen kann daher bei jedem einzelnen Anschlußelement ungehindert vorgenommen werden.

Für Lichtwellenleiter kommen als Verbinderbauteile im wesentlichen Steckverbinder in Frage, die man in entsprechenden Aufnahmen des Verteilers anordnen kann. Die Lichtwellenleiter sind bei zu enger Biegung bruchgefährdet, so daß es sich empfiehlt, die Lichtwellenleiter möglichst geradlinig von der Gestellseite her an die Verbinderbauteile heranzuführen. Eine Steckbarkeit an der Frontseite der Aufnahmen ist daher erheblich erschwert.

Der Erfindung liegt die Aufgabe zugrunde, die Zugänglichkeit zu den Verbinderbauteilen zu verbessern, ohne die Lichtwellenleiter einer erhöhten Bruchgefahr auszusetzen.

Diese Aufgabe wird durch die Erfindung gemäß Anspruch 1 gelöst. Durch die Bewegbarkeit der Aufnahmen können diese so weit aus dem Blockverbund herausbewegt werden, daß die z.B. - schachtelartigen Aufnahmen offen liegen und die darin befestigten Verbinderbauteile gut zugänglich sind. Dadurch ist es möglich, die Lichtwellenleiter von der Rückseite der Aufnahmen her biegungsarm an diese heranzuführen.

Vorteilhafte Weiterbildungen der Erfindung sind in den Ansprüchen 2 bis 11 gekennzeichnet:

Durch die Weiterbildung nach Anspruch 2 ist es möglich, die Aufnahmen einzeln aus dem Blockverband zu lösen ohne die Lichtwellenleiter zu stark zu verbiegen. Durch Wegschwenken ganzer Verteilerblöcke wird der hinter diesen liegende Verdrahtungsraum besser zugänglich, so daß Änderungen im Verlauf der Lichtwellenleiter z.B. bei Rangierungen leichter durchgeführt werden können.

Durch die Weiterbildung nach Anspruch 3 wird die Aufnahme von den Umlenkpunkten des Gestells entfernt angeordnet, daß sich die Krümmungsradien der Lichtwellenleiter beim Verschwenken nicht stark ändern.

Durch die seitliche Anordnung der Haltestäbe nach Anspruch 4 können die Lichtwellenleiter ungehindert auf der Rückseite der Aufnahme an diese herangeführt werden.

Die Weiterbildung nach Anspruch 5 ermöglicht ein seitliches Verschwenken der Aufnahmen, ohne daß diese dabei ihre Winkellage verändern. Durch die Befestigung an zwei Haltestäben, wird die Lagerung der Aufnahmen erheblich stabiler.

Durch die Weiterbildung nach Anspruch 6 ist es möglich, zwei benachbarte Aufnahmeblöcke in entgegengesetzter Richtung auseinander zu - schwenken, so daß der dahinterliegende Verdrahtungsraum noch besser zugänglich wird.

Durch die Weiterbildung nach Anspruch 7 ist es möglich, die einzelnen Aufnahmen mit engem Blockabstand am Gestell zu befestigen. Die einzelnen Aufnahmen können so weit aus dem Block herausgezogen werden, daß die Verbinderbauteile gut zugänglich sind.

Die Kabelschlaufe nach Anspruch 8 bildet eine Leitungsreserve für das Herausziehen der Aufnahmen. Die Weiterbildungen nach den Ansprüchen 9 und 10 ermöglichen eine besonders gute Führung der Aufnahmen.

Durch die Weiterbildung nach Anspruch 11 können die Aufnahmen besonders weit und über den Blockraum hinaus herausgezogen werden.

Im folgenden wird die Erfindung anhand von in der Zeichnung dargestellten Ausführungsbeispielen näher erläutert.

Es zeigen:

Fig. 1 schematisiert eine perspektivische Ansicht eines Verteilers für Lichtwellenleiter,

Fig. 2 schematisiert eine perspektivische Ansicht eines anderen Verteilers für Lichtwellenleiter,

Fig. 3 einen Teil des Verteilers nach Fig. 2.

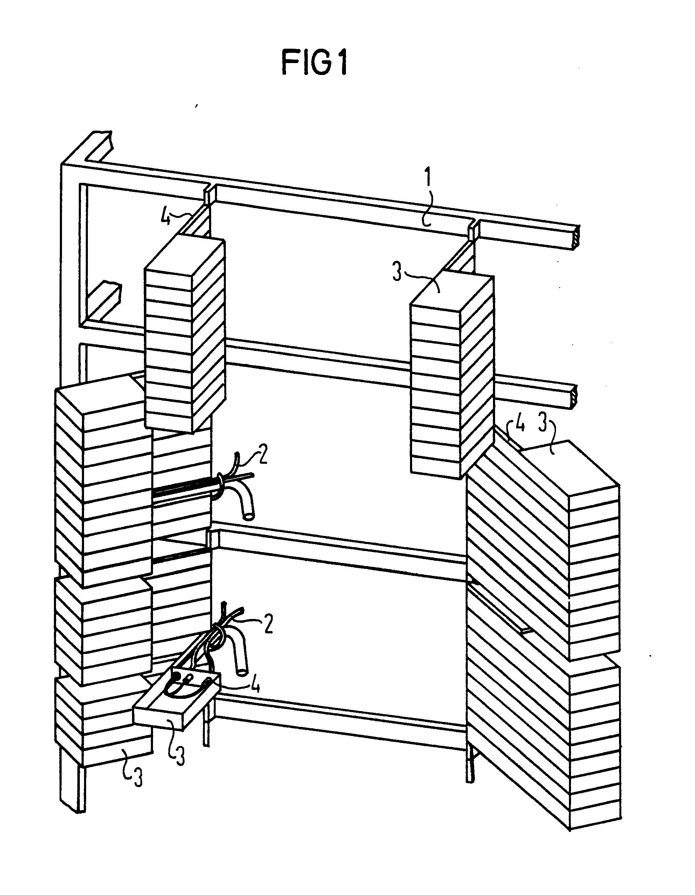

Nach Fig. 1 sind an einem Gestell 1 eines Verteilers für Lichtwellenleiter 2 zwei Schwenkachsen befestigt, an denen schachtelartige Aufnahmen 3 für Verbinderbauteile 4 zum Verbinden der Lichtwellenleiter 2 schwenkbar gelagert sind. In der gezeigten Frontansicht sind die beiden oberen Gruppen von blockartig aufeinandergeschichteten Aufnahmen 3 in ihrer Normalstellung dargestellt, in der sie senkrecht zur Verteilerebene stehen. Die unteren Aufnahmen 3 sind nach rechts und links weggeschwenkt, so daß der hinter den Aufnahmen 3 liegende Verdrahtungsraum gut zugänglich wird. Dabei ist eine der Aufnahmen in ihrer Normalstellung stehen geblieben. Diese tritt nun aus dem Blockverband der übrigen Aufnahmen 3 heraus, so daß ihre Verbinderbauteile 4 offen zugänglich sind. Die Lichtwellenleiter 2 sind von der Rückseite her an die Aufnahmen herangeführt. Die Aufnahmen 3 sind durch einen Haltestab 4 mit Abstand zum Gestell 1 gehalten. Sie sind seitlich an die Aufnahmen 3 herangeführt, so daß auf der Rückseite der Aufnahme hinreichend Platz zur Verlegung der Lichtwellenleiter 2 gegeben ist. Durch die Haltestäbe 4 werden die Lichtleiter 2 beim Wegschwenken der Aufnahmen 3 nur wenig gekrümmt. Die Haltestäbe sind mit ihrem freien Ende am Gestell 1 schwenkbar gelagert. Dadurch liegt der Drehpunkt so weit von den Aufnahmen 3 entfernt, daß diese mühelos aus dem Blockverband herausgeschwenkt werden können.

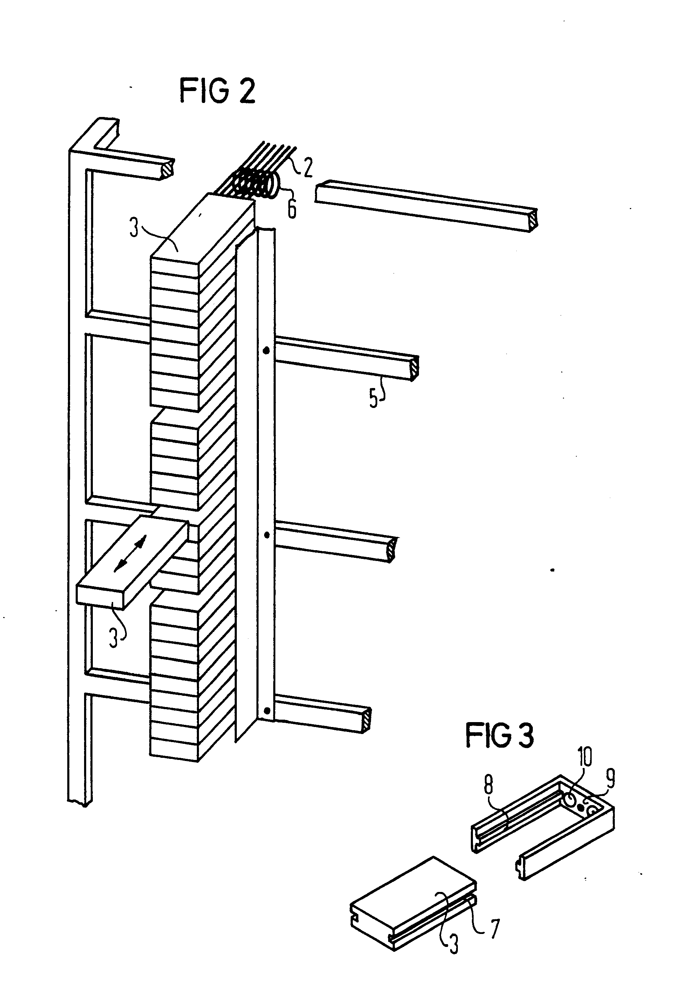

Nach Fig. 2 sind die schachtelartigen Aufnahmen 3 entsprechend der Pfeilrichtung an einem anderen Gestell 5 eines Verteilers für Lichtwellenleiter senkrecht zur Frontseite verschiebbar gelagert.

Auf der Rückseite der Aufnahmen 3 sind die Lichtwellenleiter 2 in einer Schlaufe 6 verlegt, die eine Längenreserve für das Ziehen der Aufnahmen 3 darstellt.

Die Aufnahme 3 kann durch geeignete Führungsmittel so weit aus den übrigen blockartig aufeinandergeschichteten Aufnahmen 3 in Richtung der Frontseite herausgezogen werden, daß die darin gehaltenen Verbinderbauteile, z.B. Steckverbinder frei zugänglich sind.

Nach Fig. 3 ist eine Aufnahme 3 mit beidseitigen Führungsnuten 7 versehen, in die entsprechende schienenartige Führungsstücke 8 eines U-förmigen Führungsbügels 9 eingreifen können. Der Führungsbügel 9 ist in seiner Basis mit Durchgangslöchern 10 zum Durchtritt der Lichtwellenleiter versehen.

Bezugszeichenliste

   1 Gestell
   2 Lichtwellenleiter
   3 Aufnahmen
   4 Verbinderbauteile
   5 anderes Gestell
   6 Schlaufe
   7 Führungsnuten
   8 Führungsstücke
   9 Führungsbügel
   10 Durchgangslöcher

**Ansprüche**

1. Verteiler für Lichtwellenleiter mit schichtartig aneinandergereihten Aufnahme für Verbinderbauteile, die an einem Gestell des Verteilers gelagert sind,

**dadurch gekennzeichnet** ,

daß die Aufnahmen (3) in der Schichtebene einzeln bewegbar am Gestell gehalten sind und daß die Lichtleiter (2) auf der Rückseite der Aufnahmen (3) an diese herangeführt sind.

2. Verteiler nach Anspruch 1,

**dadurch gekennzeichnet,**

daß die Aufnahmen (3) einzeln oder blockweise - schwenkbar gelagert sind.

3. Verteiler nach Anspruch 2,

**dadurch gekennzeichnet** ,

daß die Aufnahmen an einem Haltestab (4) befestigt sind, der am Gestell (1) schwenkbar gelagert ist.

4. Verteiler nach Anspruch 3,

**dadurch gekennzeichnet** ,

daß der Haltestab (4) in der Verlängerung zumindest einer der beiden Schmalseiten der Aufnahme (3) an diese angesetzt ist.

5. Verteiler nach Anspruch 4,

**dadurch gekennzeichnet** ,

daß zwei Haltestäbe mit je zwei Schwenkpunkten vorgesehen sind, an denen die Aufnahme trapezartig schwenkbar gelagert ist.

6. Verteiler nach einem der vorhergehenden Ansprüche,

**dadurch gekennzeichnet** ,

daß die Aufnahmen (3) aus ihrer Normalstellung in beiden Richtungen schwenkbar sind.

7. Verteiler nach einem der vorhergehenden Ansprüche,

**dadurch gekennzeichnet** ,

daß die Aufnahmen (3) senkrecht zur Frontseite am Gestell (1) verschiebbar gelagert sind.

8. Verteiler nach Anspruch 7,

**dadurch gekennzeichnet** ,

daß im Rückraum der Aufnahmen (3) eine Kabelschlaufe (6) für die Lichtwellenleiter (2) vorgesehen ist.

9. Verteiler nach Anspruch 7 oder 8,

**dadurch gekennzeichnet,**

daß die Aufnahmen (3) in schienenartigen Führungsstücken (8) gelagert sind.

10. Verteiler nach Anspruch 9,

**dadurch gekennzeichnet ,**

daß die Führungsstücke (8) Teil eines U-förmig verlaufenden Führungsbügels (9) sind, der am Gestell (1) befestigt ist.

11. Verteiler nach einem der Ansprüche 7 bis 10,

**dadurch gekennzeichnet ,**

daß die Aufnahmen in einer teleskopartigen Führung gelagert sind.

# FIG 1

## FIG 2

## FIG 3

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | DE-B-1 162 417 (SIEMENS)<br>* Figur; Spalte 3, Zeilen 27-68; Spalte 4, Zeilen 1-12; Ansprüche * | 1 | G 02 B 6/44 |
| A | | 2,4,10 | |
| | --- | | |
| Y | FR-A-2 515 466 (LIGNES TELEGRAPHIQUES ET TELEPHONIQUES)<br>* Figuren; Seite 2, Zeilen 10-27; Seite 6, Zeilen 26-28 * | 1 | |
| | --- | | |
| A | US-A-4 258 965 (H.I. STONER)<br>* Figur; insgesamt * | 7,11 | |
| | --- | | |
| A | PATENTS ABSTRACTS OF JAPAN, vol. 7, no. 198 (P-220)[1343], 2. September 1983; & JP-A-58 98 714 (NIPPON DENSHIN DENWA KOSHA) 11-06-1983<br>* Figur; insgesamt * | 8 | RECHERCHIERTE SACHGEBIETE (Int. Cl.4)<br><br>G 02 B 6/00<br>H 04 Q 1/00<br>H 05 K 7/00 |
| | --- | | |
| A | GB-A-1 024 419 (SIEMENS)<br>* Figur 4; Seite 2, Zeilen 73-99 * | 9 | |
| | ----- | | |

Der vorliegende Recherchenbericht wurde für alle Patentansprüche erstellt.

| Recherchenort | Abschlußdatum der Recherche | Prüfer |
|---|---|---|
| DEN HAAG | 11-10-1986 | MATHYSSEK K. |